# EUROPÄISCHE PATENTANMELDUNG

(11) **EP 4 592 057 A1**
(43) Veröffentlichungstag der Anmeldung: **30.07.2025**
(21) Anmeldenummer: 25154481.3
(22) Anmeldetag: 28.01.2025
(51) Int. Cl.: B29C 49/80, B29C 49/42, B29C 49/12, B29K 67/00, B29L 31/00, B65D 23/02, G01N 15/08

(54) **VERFAHREN ZUR PRODUKTION UND QUALITÄTSPRÜFUNG VON MITTELS PLASMA BESCHICHTETEN KUNSTSTOFFFLASCHEN**

(30) Priorität: 29.01.2024 DE 102024102398
(71) Anmelder: KHS GmbH, 44143 Dortmund (DE)
(72) Erfinder: Beyersdorff, Björn, 44143 Dortmund (DE); Behling, Manuela, 44143 Dortmund (DE)
(74) Vertreter: Andrejewski - Honke Patent- und Rechtsanwälte Partnerschaft mbB

(57) **Zusammenfassung**

Die Erfindung betrifft ein Verfahren zur Produktion und Qualitätsprüfung von mittels Plasma beschichteten Kunststofffaschen, insbesondere PET-Kunststoffflaschen, wobei in einem Produktionsbetrieb blasgeformte Kunststoffflaschen einer vorgegebenen Art in einem Plasmabeschichtungsprozess mit einer innenliegenden Barriereschicht versehen werden, wobei aus dem Produktionsbetrieb beschichtete Kunststoffflaschen als Prüfmuster ausgeschleust werden, wobei an zumindest einem Teil der Prüfmuster in einem ersten Prüfschritt durch eine Fluidbeaufschlagung eine druckabhängige Expansion bei zumindest einem Messdruck bestimmt und mit Referenzdaten (1) verglichen wird, wobei an zumindest einem Teil der Prüfmuster in einem zweiten Prüfschritt nach einer Druckbeaufschlagung eine Gasdurchlässigkeit bestimmt wird, wobei die bestimmte Gasdurchlässigkeit mit einer vorbestimmten Referenzbeziehung (2) zwischen druckabhängiger Expansion und Gasdurchlässigkeit verglichen wird und wobei ausgehend von dem Vergleich mit der Referenzbeziehung (2) eine qualitative Kategorisierung des Plasmabeschichtungsprozesses erfolgt.

## Beschreibung

Die Erfindung betrifft ein Verfahren zur Produktion und Qualitätsprüfung von mittels Plasma beschichteten Kunststoffflaschen, insbesondere PET-Kunststoffflaschen.

In der Getränkeindustrie oder auch für andere flüssige oder pastöse Produkte werden in der Praxis Kunststoffbehälter und insbesondere Kunststoffflaschen eingesetzt. Weit verbreitet sind Flaschen aus PET (Polyethylenterephthalat), welche sich durch gute Funktionseigenschaften einschließlich einer guten Recyclingfähigkeit auszeichnen.

Obwohl PET im Vergleich zu vielen anderen Kunststoffen bereits gute Barriereeigenschaften aufweist, besteht bei karbonisierten Produkten, empfindlichen Produkten oder besonders hohen Qualitätsanforderungen das Bedürfnis, die Barriereeigenschaften weiter zu verbessern. Hierzu ist es bekannt, die Behälterwand mit einer inneren Barriereschicht zu versehen. Hierzu können dünne Schichten aus Kohlenwasserstoffverbindungen oder dünne quarzglasähnliche Schichten insbesondere auf der Basis von SiOₓ vorgesehen sein (siehe "Blasformen von Kunststoffkörpern", 2., aktualisierte Auflage 2022, Michael Thielen, Klaus Hartwig, Peter Gust, ISBN 978-3-446-45552-8, Seiten 211 bis 213).

Entsprechende Vorrichtungen und Verfahren sind auch in der EP 3 433 395 B1, der DE 102 25 609 A1 und der WO 03/100120 A2 beschrieben.

Die Abscheidung zumindest einer dünnen Schicht erfolgt durch ein Plasmaverfahren, welches auch mehrstufig durchgeführt werden kann. Die gegebenenfalls auch in Form von mehreren Schichten aufgebrachte Beschichtung dient insbesondere einem besseren Schutz der abgefüllten Produkte, wobei gerade eine Migration von Sauerstoff und Kohlendioxid wesentliche Kriterien darstellen. Gerade bei empfindlichen Füllgütern können oxidative Prozesse zu einer Geschmacksbeeinträchtigung oder einem Verderben des Füllproduktes führen. Dabei ist auch die Lagerfähigkeit der Produkte von besonderer Bedeutung. Umso besser die Barrierewirkung ist, umso länger können auch empfindliche Produkte, wie beispielsweise frische Milchprodukte, frische Säfte oder dergleichen, gelagert werden. Bei karbonisierten Produkten wird durch die Barrierewirkung der Verlust von Kohlendioxid vermieden bzw. verringert, so dass sich auch dort eine verbesserte Lagerfähigkeit ergibt.

Dünne quarzglasähnliche Schichten auf der Basis von SiOₓ zeichnen sich vor diesem Hintergrund durch eine universelle Barrierewirkung gegenüber unterschiedlichen Gasen und eine hohe Transparenz aus.

Bei der Auslegung einer Flasche kann die Lagerfähigkeit von Produkten anhand von theoretischen Vorhersagen und/oder Versuchen bestimmt werden. Bei einer Massenproduktion ist es jedoch möglich, dass durch Abweichungen im Produktionsbetrieb Qualitätsanforderungen an die Lagerfähigkeit des Füllgutes nicht eingehalten werden.

In einem solchen Fall ist problematisch, dass eine Vielzahl von Einflussgrößen in Betracht kommt. Grundsätzlich ist es denkbar, dass die dem Produktionsprozess zugeführten Komponenten und Bestandteile mangelhaft sind. Beispielsweise kann das Füllgut bereits von vornherein eine nicht ausreichende Qualität oder auch Verunreinigungen aufweisen, die zu einer geringeren Lagerfähigkeit beitragen.

Als weiteres Vorprodukt des Produktionsprozesses werden dem Verfahren PET-Vorformlinge zugeführt, wobei sich auch hier Produktionsschwankungen erheblich auswirken können. Darüber hinaus können Produktionsveränderungen bei dem Ausformen der Kunststoffflaschen durch Blasformen, insbesondere Streck-Blasformen, bei dem Plasmabeschichtungsprozess und/oder bei dem Füllprozess zu Qualitätsschwankungen führen.

Vor diesem Hintergrund kann es schwierig sein, Qualitätsschwankungen zuzuordnen und dann gegebenenfalls zu beseitigen.

Aus der Praxis ist es bekannt, zur Qualitätssicherung beschichtete Flaschen verschiedenen Untersuchungen zu unterziehen. Grundsätzlich ist es möglich, mit dem Füllgut befüllte Behälter einzulagern und dann die Qualität des Füllgutes zu testen. Dabei ergibt sich ein sehr großer Zeitverzug, sodass nicht mehr oder nur mit einer erheblichen Verzögerung in den Produktionsprozess eingegriffen werden kann.

Deshalb ist es auch zweckmäßig, den Lagerungs- und Alterungsprozess in einem kürzeren Zeitraum nachzustellen. So ist in der Praxis unter anderem vorgesehen, dass beschichtete Flaschen mit Natriumhydrogencarbonat und Weinsäure chemisch karbonisiert werden, sodass der CO₂-Gehalt dem späteren Füllgut entspricht. Die Flaschen werden dann 24 Stunden bei 38 °C gelagert, sodass durch die erhöhte Temperatur ein schnellerer Alterungsprozess nachgestellt wird. Anschließend werden die Flaschen entleert, wobei dann die Barriereeigenschaften, insbesondere die Sauerstoffdurchlässigkeit (OTR), gemessen werden. Des Weiteren ist es auch bekannt, Flaschen optisch vor und nach der Lagerung zu vermessen, um bei etwaigen Maßabweichungen Rückschlüsse auf Qualitätsbeeinträchtigungen ziehen zu können.

Es ist bekannt, dass bei beschichteten Kunststoffflaschen mit einer innenliegenden Barriereschicht eine Ausdehnung des PET-Substrates zu Rissen in der aufgebrachten Schicht und damit zu einer Reduzierung der Barrierewirkung führt, weil unmittelbar an den Rissen die Barrierewirkung nicht oder nur eingeschränkt vorhanden ist und dort eine erhöhte Diffusion auftreten kann.

Wenn also eine entsprechend beschichtete Kunststoffflasche bei der Produktion oder Lagerung einem zu hohen Druck ausgesetzt ist und/oder wenn diese eine zu geringe Festigkeit aufweist, ist auch bei einem ordnungsgemäßen Plasmabeschichtungsprozess eine geringere Barrierewirkung und somit eine geringere Lagerfähigkeit der Füllgüter zu erwarten. Andererseits kann eine zu große Gasdurchlässigkeit und insbesondere Sauerstoffdurchlässigkeit und damit eine reduzierte Lagerfähigkeit unter Umständen auch auf einen fehlerhaften bzw. nicht optimalen Plasmabeschichtungsprozess zurückzuführen sein.

In der Praxis ist eine Unterscheidung der verschiedenen Einflussfaktoren schwierig, sodass gegebenenfalls die Angabe einer zu erreichenden Lagerfähigkeit vergleichsweise große Produktionsschwankungen berücksichtigen muss und dann das tatsächliche Potenzial der beschichteten Kunststoffflaschen nicht ausgeschöpft wird. Nachteilig ist es insbesondere auch, wenn im Rahmen der bekannten Analysen die Qualität von beschichteten Kunststoffflaschen erst mit einer erheblichen Verzögerung ermittelt werden kann.

Der Erfindung liegt die Aufgabe zugrunde, ein Verfahren zur Produktion und Qualitätsprüfung von mittels Plasma beschichteten Kunststoffflaschen anzugeben, welches hinsichtlich verschiedener Einflussquellen vergleichsweise schnell und zuverlässig ist und verschiedene Fehlerquellen auch in einem gewissen Maße unterscheiden kann.

Gegenstand der Erfindung und Lösung der Aufgabe ist ein Verfahren zur Produktion und Qualitätsprüfung von mittels Plasma beschichteten Kunststoffflaschen, insbesondere PET-Kunststoffflschen, wobei in einem Produktionsbetrieb blasgeformte und insbesondere streckblasgeformte Kunststoffflaschen einer vorgegebenen Art in einem Plasmabeschichtungsprozess mit einer innenliegenden Barriereschicht versehen werden, wobei aus dem Produktionsbetrieb beschichtete Kunststoffflaschen als Prüfmuster ausgeschleust werden, wobei an zumindest einem Teil der Prüfmuster in einem ersten Prüfschritt durch eine Fluidbeaufschlagung eine druckabhängige Expansion bei zumindest einem Messdruck bestimmt und mit Referenzdaten verglichen wird, wobei an zunächst einem Teil der Prüfmuster in einem zweiten Prüfschritt nach einer Druckbeaufschlagung eine Gasdurchlässigkeit bestimmt wird, wobei die bestimmte Gasdurchlässigkeit mit einer vorbestimmten Referenzbeziehung zwischen druckabhängiger Expansion und Gasdurchlässigkeit verglichen wird und wobei ausgehend von dem Vergleich mit der Referenzbeziehung eine qualitative Kategorisierung des Plasmabeschichtungsprozesses erfolgt.

Die Kategorisierung des Plasmabeschichtungsprozesses kann im einfachsten Fall in zwei Stufen beispielsweise in die Kategorien "in Ordnung" und "nicht in Ordnung" erfolgen. Wenn der Plasmabeschichtungsprozess als "nicht in Ordnung" kategorisiert ist, kann dann eine Fehlersuche bzw. Beseitigung erfolgen. Alternativ ist aber auch eine mehrstufige oder eine kontinuierliche numerische Kategorisierung möglich, wobei dann abhängig von dem Ergebnis beispielsweise eine kurzfristige Fehlersuche erfolgen oder auch mittel- oder langfristig eine Wartung geplant werden kann.

Die vorliegende Erfindung bezieht sich auf den Produktionsbetrieb der Kunststoffflaschen einer vorgegebenen Art, wobei dann für den ersten Prüfschritt die Referenzdaten und für den zweiten Prüfschritt eine Referenzbeziehung vorab hinterlegt bzw. bestimmt werden müssen.

Die Kunststoffflaschen einer vorgegebenen Art weisen insbesondere ein vorgegebenes Flaschenvolumen und eine vorgegebene Flaschenform vor. Des Weiteren können auch weitere spezifische Eigenschaften, wie beispielsweise die Art des vorgesehenen Füllgutes und weitere Parameter im Sinne eines Maschinenrezeptes berücksichtigt werden.

Dabei versteht sich, dass zweckmäßigerweise für Kunststoffflaschen unterschiedlicher Arten, also insbesondere unterschiedlicher Abmessungen und/oder Füllgrößen, jeweils spezifische Referenzdaten und Referenzbeziehungen hinterlegt bzw. bestimmt werden.

Bei dem ersten Prüfschritt wird zumindest ein Teil der Prüfmuster mit einem Fluid, beispielsweise Wasser, beaufschlagt, wobei dann bei einem vorgegebenen Messdruck oder einem vorgegebenen Druckverlauf die druckabhängige Expansion bestimmt wird. Dabei ist es von Vorteil, wenn als Fluid Wasser oder eine andere im Wesentlichen inkompressible Flüssigkeit eingesetzt wird, sodass dann für die Bestimmung der Expansion auf einfache Weise die Menge bzw. das Volumen der mit steigendem Druck hinzugefügten Flüssigkeit gemessen werden kann. Dabei ist eine dichte Anordnung der Prüfmuster der zugeordneten Messeinrichtung von besonderer Relevanz, weil durch einen etwaigen Fluidaustritt das Messverfahren erheblich verfälscht werden könnte.

Wie bereits dargelegt, kann eine Dehnung des PET-Substrates der beschichteten Flasche mit der innenliegenden Barriereschicht zu Rissen in der Barriereschicht führen.

Die Volumenzunahme der beschichteten Kunststoffflaschen in dem ersten Prüfschritt hängt dabei jedoch auch von der Flaschenform und -größe ab. Die Flasche kann beispielsweise Wellen, Sicken oder dergleichen aufweisen. Auch wenn Kunststoffflaschen häufig rotationssymmetrisch sind, sind auch andere Flaschenformen bekannt. Die Volumenzunahme bei der Druckbelastung kann somit sowohl auf eine makroskopische Verformung des Flaschenkörpers ohne eine Ausdehnung des PET-Substrates als auch die Ausdehnung des PET-Substrates selbst zurückzuführen sein.

Vor diesem Hintergrund ist es klar, dass für Kunststoffflaschen unterschiedlicher Art zumindest bei erheblichen geometrischen Abweichungen separate Referenzdaten und Referenzbeziehungen zugrunde gelegt werden müssen.

Zur Festlegung der Referenzdaten kann beispielsweise vorgesehen sein, dass bei ordnungsgemäßen Kunststoffflaschen einer vorgegebenen Art, beispielsweise zu Beginn eines Produktionsprozesses oder bei der Definition eines Produktionsprozesses, die druckabhängige Expansion des Volumens bei verschiedenen Messdrücken geprüft wird. Beispielsweise können hierzu in einem Bereich von 3 bar bis 12 bar, insbesondere 5 bar bis 10 bar, Messungen durchgeführt werden, wobei zweckmäßigerweise mehrere Messungen für jede Druckstufe für eine Fehlerkorrektur vorgesehen sind.

Für die dafür eingesetzten Prüfmuster kann dann nach einem üblichen Verfahren die Gasdurchlässigkeit und insbesondere die Sauerstoffdurchlässigkeit (OTR) bestimmt werden. Es ergibt sich damit zunächst eine Beziehung zwischen dem Messdruck und der resultierenden Sauerstoffdurchlässigkeit OTR.

Für Kunststoffflaschen einer vorgegebenen Art ergibt sich dann also bei einem bestimmten Messdruck sowohl eine bestimmte Volumenexpansion als auch eine bestimmte Sauerstoffdurchlässigkeit.

Auf der Basis dieser Messwerte kann dann im Rahmen der Erfindung auch die Referenzbeziehung zwischen der druckabhängigen Expansion, in der Regel bezogen auf die Volumenzunahme, und die Gasdurchlässigkeit, insbesondere Sauerstoffdurchlässigkeit, bestimmt werden.

Durch die Durchführung des ersten Prüfschrittes und des zweiten Prüfschrittes im Rahmen der Erfindung können verschiedene negative Einflüsse im Rahmen des Produktionsprozesses unterschieden werden.

Wenn beispielsweise aufgrund einer mangelhaften Qualität der Vorformlinge und/oder Abweichungen in der Verfahrensführung, wie beispielsweise eine unzureichende Wanddickenverteilung, in dem ersten Prüfschritt im Vergleich mit den Referenzdaten eine zu starke druckabhängige Expansion bei einem vorgegebenen Messdruck ermittelt wird, so kann die Schlussfolgerung gezogen werden, dass die Kunststoffflaschen keine ausreichende Stabilität aufweisen, was durch die dann erhöhte Ausdehnung des PET-Substrates auch zu einer zu starken Beschädigung einer an sich ordnungsgemäß aufgebrachten Beschichtung führen kann.

Im Rahmen der Erfindung kann vor diesem Hintergrund vorgesehen sein, dass bei einer Abweichung der druckabhängigen Expansion von den Referenzdaten außerhalb eines vorgegebenen Toleranzbereiches, insbesondere bei einer zu starken Expansion im Vergleich zu den Referenzdaten, der Produktionsbetrieb angehalten und/oder durch eine zentrale Maschinensteuerung angepasst wird.

Der Produktionsbetrieb ist insbesondere dann anzuhalten, wenn absehbar ist, dass die produzierten Kunststoffflaschen Vorgabewerte für die Lagerfähigkeit der Produkte nicht erreichen können und wenn keine geeigneten Gegenmaßnahmen ersichtlich sind, um die Vorgabewerte wieder einhalten zu können.

Selbstverständlich ist dabei auch eine mehrstufige Verfahrensführung denkbar, wobei beispielsweise zunächst eine Warnmeldung ausgegeben wird, wenn Vorgabewerte zunächst nur leicht überschritten werden.

Hinsichtlich eines Eingriffs über die Maschinensteuerung sind verschiedene Konstellationen denkbar. Bei einer regelmäßigen Messung im Rahmen des ersten Prüfschrittes können beispielsweise Parameter des Blasprozesses einschließlich der vorherigen Erwärmung der Vorformlinge geprüft und/oder angepasst werden, wobei dann durch eine weitere Kontrolle im Rahmen des ersten Prüfschrittes die Wirkung etwaiger Anpassungen unmittelbar festgestellt werden kann.

Unter Umständen ist es auch denkbar, bei einer zu starken Dehnung der Kunststoffflaschen den Plasmabeschichtungsprozess - falls möglich - speziell zu optimieren. Beispielsweise wäre es dann auch denkbar, zusätzliche Schichten der Beschichtung vorzusehen, um eine zu starke Dehnung der Kunststoffflaschen in einem gewissen Maße ausgleichen zu können. Hierzu könnte dann gegebenenfalls auch die Produktionsgeschwindigkeit insgesamt reduziert werden.

Zusätzlich zu dem ersten Prüfschritt ist im Rahmen der Erfindung auch der zweite Prüfschritt vorgesehen, bei dem nach einer Druckbeaufschlagung eine Gasdurchlässigkeit, insbesondere eine Sauerstoffdurchlässigkeit, bestimmt wird. Beide Prüfschritte werden zumindest mit einem Teil der ausgeschleusten Prüfmuster durchgeführt, wobei grundsätzlich auch weitere Prüfmuster anderen Qualitätskontrollen unterzogen werden können.

Vorzugsweise ist vorgesehen, dass sämtliche Prüfmuster, die in dem zweiten Prüfschritt untersucht werden, zuvor in dem ersten Prüfschritt mit dem Messdruck beaufschlagt wurden, wobei der Messdruck dann auch hinsichtlich des Vergleiches mit der Referenzbeziehung zugrunde gelegt werden kann.

In dem zweiten Prüfschritt wird ermittelt, ob die bei einem spezifischen Prüfmuster festgestellte druckabhängige Expansion und eine damit verbundene Schädigung der Beschichtung zu einer zu erwartenden Gasdurchlässigkeit, insbesondere Sauerstoffdurchlässigkeit führt. Falls dann im Rahmen des zweiten Prüfschrittes in Abweichung von der Referenzbeziehung bei einer bestimmten druckabhängigen Expansion eine größere Gasdurchlässigkeit und insbesondere Sauerstoffdurchlässigkeit als erwartet festgestellt wird, so kann die Abweichung dann in der Regel auf einen nicht ordnungsgemäßen Plasmabeschichtungsprozess zurückgeführt werden. Falls dagegen bei einer festgestellten druckabhängigen Expansion die Gasdurchlässigkeit und insbesondere die Sauerstoffdurchlässigkeit in einem zu erwartenden, vorgegebenen Bereich liegt, wird ein ordnungsgemäßer Ablauf des Plasmabeschichtungsprozesses bestätigt.

Der erste Prüfschritt und der zweite Prüfschritt sind mit einem deutlich unterschiedlichen Aufwand verbunden. Der erste Prüfschritt kann beispielsweise während der laufenden Produktion regelmäßig mit einem Druckprüfgerät durchgeführt werden, wobei entsprechende Produkte kommerziell erhältlich sind. Geeignet ist beispielsweise ein Druckprüfgerät PPT3000 der Agr International, Inc.

Beispielsweise kann vorgesehen sein, dass in dem Produktionsbetrieb der erste Prüfschritt zwischen 1- bis 50-mal pro Tag durchgeführt wird, sodass dann während der gesamten Produktion dauerhaft eine gewisse Qualitätssicherung mit besonders einfachen Mitteln möglich ist.

Der zweite Prüfschritt, der mit einem deutlich größeren Aufwand verbunden ist, kann beispielsweise 1- bis 20-mal pro Woche durchgeführt werden, wobei sich dann in Kombination eine besonders zuverlässige Qualitätsprüfung mit einem vergleichsweise geringen Aufwand ergibt.

Wie zuvor erläutert, ist es bei der Festlegung bzw. Bestimmung der Referenzdaten und der Referenzbeziehung zweckmäßig, wenn Messwerte in einem gewissen Bereich des Messdruckes von beispielsweise 3 bar bis 12 bar aufgenommen werden.

Für den eigentlichen ersten Prüfschritt kann es dann ausreichend sein, wenn lediglich bei einem Druck innerhalb des angegebenen Bereiches, beispielsweise 5 bar, eine Prüfung erfolgt. Bereits anhand einer solchen einzelnen Prüfung bei einem Messdruck sind dann Abweichungen von den Referenzdaten feststellbar.

Der Messdruck kann dabei insbesondere so gewählt werden, dass dieser in etwa dem Druck entspricht, der bei der Aufnahme des Füllgutes bei einer Lagerung erwartet wird. Bei üblichen Erfrischungsgetränken ist beispielsweise ein Druck von etwa 5,2 bar üblich.

Die Fluidbeaufschlagung mit dem Messdruck kann in dem ersten Prüfschritt über einen geeigneten Zeitraum von beispielsweise 5 s bis 30 s, exemplarisch 10 s, erfolgen. Neben der Einstellung eines definierten Druckes ist grundsätzlich auch ein Druckverlauf denkbar. Hinsichtlich einer einfachen Handhabung ist jedoch in vielen Fällen die Prüfung bei einem vorgegebenen Messdruck und einer vorgegebenen Messzeit ausreichend.

Im Rahmen der Erfindung werden die Kunststoffflaschen vorzugsweise durch Streckblasen aus Polyethylenterephthalat (PET) gebildet.

Im Rahmen der vorliegenden Erfindung ist insbesondere vorgesehen, dass die beschichteten Kunststoffflaschen mit einem kohlensäurehaltigen Getränk befüllt werden, wobei sich dann, wie zuvor beschrieben, bei der Lagerung ein erheblicher Druck innerhalb der Kunststoffflaschen ausbilden kann. Die beschichteten Kunststoffflaschen können aber auch für andere empfindliche Füllgüter, wie beispielsweise Säfte, Milchprodukte, hochwertige Mineralwässer mit hohen Anforderungen an die sensorische Qualität oder dergleichen eingesetzt werden.

Die Erfindung wird nachfolgend anhand von Figuren exemplarisch erläutert.

Es zeigen:
- Fig. 1: ein Diagramm der Expansion von beschichteten Kunststoffflaschen in Abhängigkeit eines Messdrucks,
- Fig. 2: die Sauerstoffdurchlässigkeit von beschichteten Kunststoffflaschen in Abhängigkeit einer Druckbeaufschlagung bei unterschiedlichen Messdrücken,
- Fig. 3: eine Referenzbeziehung zwischen der druckabhängigen Expansion und der Sauerstoffdurchlässigkeit.

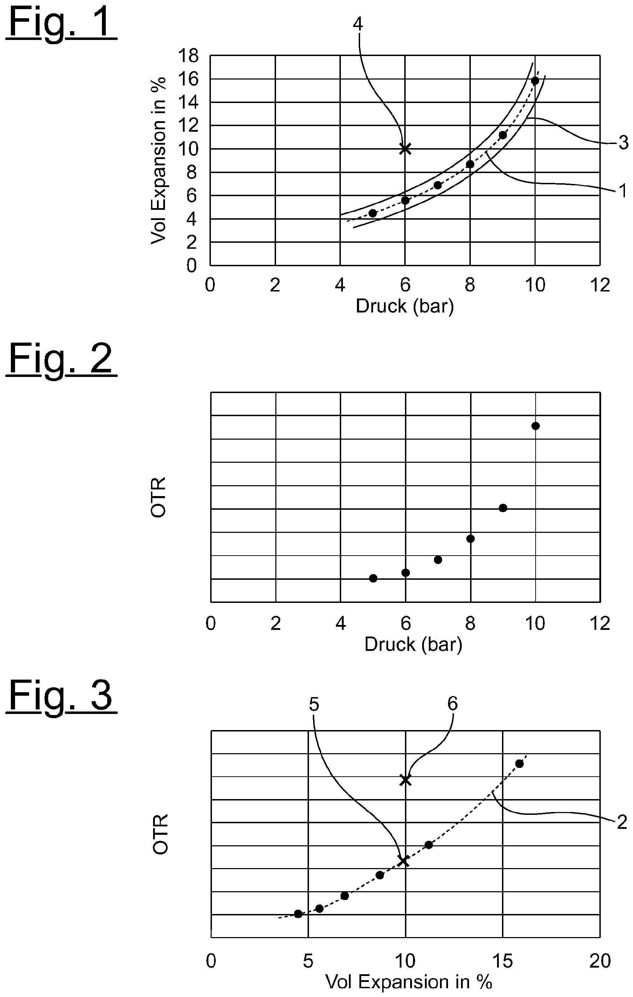

Die Fig. 1 zeigt ein exemplarisches Diagramm, in dem für Kunststoffflaschen einer vorgegebenen Art die Expansion des Volumens in Prozent bei unterschiedlichen Messdrücken von 5 bis 10 bar dargestellt ist. Die Beaufschlagung des Messdruckes kann beispielsweise über 10 s erfolgen, wobei die Messung mit einem Druckprüfgerät erfolgt, welches ausgehend von einer mit einem im Wesentlichen inkompressiblen Fluid drucklos befüllten Flasche das bei dem Einstellen des Messdruckes zusätzlich hinzufügte Volumen misst. Ein geeignetes Druckprüfgerät wird beispielsweise von dem Unternehmen Agr International, Inc. unter der Produktbezeichnung PPT3000 vertrieben.

Zweckmäßigerweise ist für die Bestimmung jedes Wertes eine Mitteilung über mehrere Messungen vorgesehen.

Es zeigt sich, dass mit zunehmendem Druck eine größere Expansion des Volumens beobachtet wird, was den üblichen Erwartungen entspricht. In dem dargestellten Beispiel betrifft die maximale Expansion des Volumens 16 % bei 10 bar, wobei dann der Berstdruck der beschichteten Flasche noch nicht erreicht ist.

Nachfolgend wird gemäß der Fig. 2 für die mit dem unterschiedlichen Messdruck beaufschlagten Kunststoffflaschen die Sauerstoffdurchlässigkeit OTR bestimmt, wobei die Fig. 2 einen qualitativen Verlauf zeigt.

Es zeigt sich, dass mit zunehmendem Druck auch die Sauerstoffdurchlässigkeit wesentlich ansteigt. Bei der ursprünglichen Bestimmung der Messwerte werden Kunststoffflaschen einer vorgegebenen Art zugrunde gelegt, welche weitgehend identisch in einem Referenzprozess gefertigt sind. Die Qualität dieser Kunststoffflaschen für die ursprüngliche Bestimmung geeigneter Referenzdaten 1 kann durch weitere Analysen bestätigt und überprüft werden. Insbesondere wird durch geeignete Maßnahmen sichergestellt, dass der Plasmabeschichtungsprozess ordnungsgemäß durchgeführt wurde.

Aus den Werten zu Fig. 1 und Fig. 2 wird gemäß der Fig. 3 auch eine Referenzbeziehung 2 zwischen der druckabhängigen Expansion und der Gasdurchlässigkeit ermittelt.

Anhand der so insgesamt bestimmten Referenzdaten 1 und der Referenzbeziehung 2 können dann in dem Produktionsbetrieb der blasgeformten Kunststoffflaschen der vorgegebenen Art im Rahmen der Erfindung Qualitätsprüfungen mit einem ersten Prüfschritt und einem zweiten Prüfschritt erfolgen.

Bei dem ersten Prüfschritt wird durch eine Fluidbeaufschlagung bei einem aus dem Produktionsbetrieb ausgeschleusten Prüfmuster eine druckabhängige Expansion bei zumindest einem Messdruck bestimmt und mit den Referenzdaten 1 gemäß der Fig. 1 verglichen.

Exemplarisch kann bei dem ersten Prüfschritt ein Messdruck von 6 bar vorgesehen sein. Sofern dann der Messwert innerhalb eines gewissen Toleranzbereiches 3 der dargestellten Referenzdaten 1 liegt, weist das Prüfmuster zumindest zu erwartende mechanische Eigenschaften, nämlich eine zu erwartende Expansion des Volumens auf.

In der Fig. 1 ist dagegen ein exemplarischer Messwert 4 bei 6 bar dargestellt, der bei einem Prüfmuster im Vergleich zu den Referenzdaten eine zu hohe Volumenexpansion von beispielsweise 10 % angibt. Dies bedeutet, dass das entsprechende Prüfmuster derart von den Referenzdaten abweicht, dass eine zu geringe Festigkeit und somit in der Regel eine zu hohe Dehnung des PET-Materials vorliegt.

Bei dem entsprechenden Prüfmuster wird dann in dem zweiten Prüfschritt nach der Druckbeaufschlagung mit einem Messdruck von 6 bar die Gasdurchlässigkeit, nämlich konkret die Sauerstoffdurchlässigkeit OTR bestimmt, wobei hierzu in der Fig. 3 exemplarisch zwei unterschiedliche Ergebnisse dargestellt sind. Gemäß einem ersten Wert 5 liegt die Sauerstoffdurchlässigkeit bei einer Volumenexpansion von 10 % im Bereich der vorbestimmten Referenzbeziehung 2.

Daraus folgt dann, dass der Plasmabeschichtungsprozess ordnungsgemäß abgelaufen ist. Es ist dann zu entscheiden, ob die in dem ersten Prüfschritt festgestellte zu hohe druckabhängige Expansion im Vergleich mit den Referenzdaten 1 noch hingenommen werden kann oder ob gegebenenfalls der Produktionsbetrieb angehalten oder angepasst werden muss.

In der Fig. 3 ist des Weiteren ein weiterer Wert 6 exemplarisch eingezeichnet, bei dem bei der Volumenexpansion von 10 % eine erhöhte Sauerstoffdurchlässigkeit festgestellt wird. Diese Abweichung von der vorbestimmten Referenzbeziehung lässt darauf schließen, dass der Plasmabeschichtungsprozess selbst nicht ordnungsgemäß abgelaufen ist und diesbezüglich eine Kontrolle bzw. Korrektur notwendig ist.

### Bezugszeichenliste

- 1: Referenzdaten
- 2: Referenzbeziehung
- 3: Toleranzbereich
- 4: Messwert
- 5: erster Wert
- 6: zweiter Wert

## Patentansprüche

1. Verfahren zur Produktion und Qualitätsprüfung von mittels Plasma beschichteten Kunststofffaschen, insbesondere PET-Kunststoffflaschen,
wobei in einem Produktionsbetrieb blasgeformte Kunststoffflaschen einer vorgegebenen Art in einem Plasmabeschichtungsprozess mit einer innenliegenden Barriereschicht versehen werden,
wobei aus dem Produktionsbetrieb beschichtete Kunststoffflaschen als Prüfmuster ausgeschleust werden,
wobei an zumindest einem Teil der Prüfmuster in einem ersten Prüfschritt durch eine Fluidbeaufschlagung eine druckabhängige Expansion bei zumindest einem Messdruck bestimmt und mit Referenzdaten (1) verglichen wird,
wobei an zumindest einem Teil der Prüfmuster in einem zweiten Prüfschritt nach einer Druckbeaufschlagung eine Gasdurchlässigkeit bestimmt wird,
wobei die bestimmte Gasdurchlässigkeit mit einer vorbestimmten Referenzbeziehung (2) zwischen druckabhängiger Expansion und Gasdurchlässigkeit verglichen wird und
wobei ausgehend von dem Vergleich mit der Referenzbeziehung (2) eine qualitative Kategorisierung des Plasmabeschichtungsprozesses erfolgt.

2. Verfahren nach Anspruch 1, wobei bei einer Abweichung der druckabhängigen Expansion von den Referenzdaten (1) außerhalb eines vorgegebenen Toleranzbereiches (3) der Produktionsbetrieb angehalten und/oder über eine zentrale Maschinensteuerung angepasst wird.

3. Verfahren nach einem der vorhergehenden Ansprüche, wobei in dem Produktionsbetrieb der erste Prüfschritt zwischen 1- bis 50-mal pro Tag durchgeführt wird.

4. Verfahren nach einem der vorhergehenden Ansprüche, wobei der zweite Prüfschritt zwischen 1- bis 20-mal pro Woche durchgeführt wird.

5. Verfahren nach einem der vorhergehenden Ansprüche, wobei für die Kunststoffflaschen der vorgegebenen Art die Referenzbeziehung (2) durch eine Messreihe bestimmt wird, bei der für eine Vielzahl unterschiedlicher Messdrücke jeweils eine Gasdurchlässigkeit bestimmt wird.

6. Verfahren nach einem der vorhergehenden Ansprüche, wobei in dem ersten Prüfschritt die Fluidbeaufschlagung bei einem Messdruck zwischen 3 und 12 bar erfolgt.

7. Verfahren nach einem der vorhergehenden Ansprüche, wobei in dem ersten Prüfschritt die Fluidbeaufschlagung über einen Zeitraum zwischen 5 s und 30 s erfolgt.

8. Verfahren nach einem der vorhergehenden Ansprüche, wobei in dem Produktionsbetrieb die Kunststofflaschen mit einem kohlensäurehaltigen Getränk befüllt werden.

9. Verfahren nach einem der vorhergehenden Ansprüche, wobei die Kunststoffflaschen aus durch Streckblasen aus Polyethylenterephthalat (PET) gebildet werden.
